# EUROPÄISCHE PATENTSCHRIFT

(11) **EP 2 250 668 B1**
(45) Veröffentlichungstag und Bekanntmachung des Hinweises auf die Patenterteilung: **21.02.2018**
(21) Anmeldenummer: 08872114.7
(22) Anmeldetag: 29.12.2008
(51) Int. Cl.: H01L 23/049, H05K 5/06, F16H 61/00, H01L 23/10

(54) **METALLISCHES GEHAEUSETEIL UND VERFAHREN ZUR HERSTELLUNG DES GEHAEUSETEILES**
METAL HOUSING PART AND METHOD FOR PRODUCING THE HOUSING PART
PIÈCE DE BOÎTIER MÉTALLIQUE ET PROCÉDÉ POUR FABRIQUER LA PIÈCE DE BOÎTIER

(30) Priorität: 04.02.2008 DE 102008007346
(43) Veröffentlichungstag der Anmeldung: 17.11.2010
(73) Patentinhaber: Robert Bosch GmbH, 70442 Stuttgart (DE)
(72) Erfinder: TRESCHER, Ulrich, 72072 Tuebingen (DE); SCHAEFER, Eckhard, 72074 Tuebingen (DE)
(86) Internationale Anmeldenummer: PCT/EP2008/068308
(87) Internationale Veröffentlichungsnummer: WO 2009/097941

(56) Entgegenhaltungen:
- DE-A1- 2 061 179
- DE-A1- 19 640 466
- DE-U1- 9 010 159
- GB-A- 918 543
- US-A- 5 227 250
- US-A1- 2003 068 907
- US-A1- 2003 209 795

## Beschreibung

Die Erfindung betrifft ein metallisches Gehäuseteil mit mehreren durchgehenden Ausnehmungen, in jeder der Ausnehmungen ist eine Glasfüllung angeordnet, jede Glasfüllung verschließt eine Ausnehmung hermetisch dicht und ummantelt einen Kontaktstift, der sich durch die Ausnehmung und die Glasfüllung hindurch erstreckt und dessen beide Enden aus der Glasfüllung und der Ausnehmung herausragen und ein Verfahren zur Herstellung des metallischen Gehäuseteiles.

Aus der DE 196 40 466 B4 ist ein solches darin als metallisches Trägerteil bezeichnetes Gehäuseteil mit auf der Bestückungsseite aufgebrachten elektronischen Bauelementen und/oder Schaltungsträgern, insbesondere Hybridschaltungen bekannt, deren Anschlüsse von der Bestückungsseite über mehrere in Glasdurchführungen eingeschmolzene Anschlußstifte bis auf die der Bestückungsseite gegenüberliegende Seite des Trägerteils hindurchgeführt sind. Das Trägerteil bildet eine Gehäusebodenplatte eines hermetisch dichten Gehäuses. Derartige Gehäuse sind beispielsweise in einem Automatikgetriebe eines Kraftfahrzeuges einsetzbar und eine darin beinhaltete elektronische Steuerung wählt Gänge aus und steuert eine Kupplung. Beim Einglasen der Anschlussstifte wird ein die Anschlussstifte aufnehmendes Teil stark erhitzt. Dabei kann sich das die Anschlussstifte aufnehmende Teil verformen. Die Anschlussstifte sind von daher auf wenigstens einer metallischen und mit Durchführungslöchern versehenen Stiftleiste angeordnet, die aus einer hochwertigen Legierung mit einem geringen Wärmeausdehnungskoeffizienten gefertigt ist. Solche Legierungen werden als Kovar oder Invar bezeichnet. Diese Stiftleiste ist in das Trägerteil einsetzbar, das aus einem kostengünstigen Edelstahl gefertigt ist. Das Trägerteil und die Stiftleiste bilden einen Gehäuseboden aus, der somit mehrteilig ausgeführt ist.
Aus der DE 26 47 623 C3 ist ein Verfahren zur Herstellung einer ein- oder mehrpoligen elektrischen Durchführung bekannt. Ein Sockel weist eine rohrförmige Seitenwand und einen Boden auf. Der Boden weist Durchführungslöcher auf, durch die Durchführungsdrähte hindurch geführt sind. Die Sockel werden von innen in ein Gehäuse eingesetzt und mit diesem verschweißt.

Aus der US-A-2003209795 ist ein Gehäuseteil gemäß dem ersten Teil des Anspruchs 1 bekannt. Der Erfindung liegt die Aufgabe zugrunde, ein einfaches Gehäuseteil und ein einfaches Verfahren zur Herstellung des Gehäuseteiles anzugeben. Diese Aufgabe wird mit den Merkmalen der Hauptansprüche gelöst. Erfindungsgemäß ist das Gehäuseteil wannenförmig mit einer Bodenwand, Seitenwänden und einem Flansch ausgebildet. Auch wenn das Gehäuseteil hohen Temperaturen ausgesetzt wird, behält das Gehäuseteil aufgrund der wannenförmigen Ausgestaltung seine ursprüngliche Form bei. Das Gehäuseteil ist einteilig ausgebildet und aus einem kostengünstigen Stahl, in vorteilhafter Weise aus einem kostengünstigen Edelstahl herstellbar.
In einfacher Weise nehmen jeweils zwei benachbarte Seitenwände einen rechten Winkel zueinander ein. Damit ist eine verwindungssteife Konstruktion erzielt, die sich auch bei hohen Temperaturen nicht verformt. Gemäß der Erfindung sind die Kontaktstifte in dem Flansch angeordnet. Die senkrecht zu einer Bodenwannenebenen stehenden Kontaktstifte sind zu dieser beabstandet. Die aus dem Gehäuse herausragenden Kontaktstifte liegen geschützt in einer Hohlkehle des Gehäuses. Die Bodenwand des Gehäuseteils ist zur besseren Wärmeableitung direkt und großflächig auf ein Teil des Automatikgetriebes aufsetzbar.

In einfacher Weise weist der Flansch eine umlaufend Nut auf. Ein Rand einer Gehäuseabdeckung ist die Nut einsetzbar und die Gehäuseabdeckung mit dem Gehäuseteil verschweißbar.

In einfacher Weise weist der Flansch zumindest eine weitere durchgehende Ausnehmung auf. Die Ausnehmung dient zur Befestigung des Gehäuseteiles beziehungsweise des Gehäuses innerhalb des Automatikgetriebes.

In einfacher Weise ist an dem Flansch zumindest eine Lasche mit einer durchgehenden Ausnehmung angeordnet. Gemäß einer weiteren Ausführungsform sind an dem Flansch Laschen angeformt, die eine Ausgestaltung des Automatikgetriebes berücksichtigen, so dass das Gehäuseteil an dem Automatikgetriebe anbringbar ist.

In vorteilhafter Weise weist die Lasche zumindest ein Laschenteil mit einer durchgehenden Ausnehmung auf, das in derselben Ebene wie die Bodenwand liegt. Nach der Befestigung innerhalb des Automatikgetriebes liegt sowohl das Laschenteil als auch die Bodenwand auf einem ebenen Automatikgetriebeteil auf. Das Gehäuse ist stabil, starr und wärmeableitend an dem Automatikgetriebeteil gehalten.

In vorteilhafter Weise ist der Flansch stufenförmig mit zwei Stufen ausgeführt. Die erste Stufe weist die durchgehenden Kontaktstiftausnehmungen und die Kontaktstifte auf. Die zweite Stufe dient zur Befestigung der Gehäuseabdeckung, die als Platte ausführbar ist.

In einfacher Weise sind die Kontaktstifte aus Edelstahl gefertigt. Damit sind diese oxidationsfrei. Geeignet ist eine Nickel Eisen Verbindung. An diese Edelstahl Kontaktstifte sind dünne Drähte zum Verbinden mit Anschlussstellen einer Hybridschaltung gut anbringbar. Ein Anbringen der Anschlussdrähte ist auch als Bonden bezeichnet.
Ein Verfahren zur Herstellung eines metallischen und wannenförmig mit einer Bodenwand, Seitenwänden und einem Flansch ausgebildeten Gehäuseteiles weist folgende Verfahrensschritte auf: Das metallische Gehäuseteil wird tief gezogen und Kontaktstifte werden in Ausnehmungen des metallischen Gehäuseteiles eingeglast. Die Kontaktstifte werden in Ausnehmungen eingeglast, die in dem Flansch angeordnet sind.
In vorteilhafter Weise ist der Wärmeausdehnungskoeffizient des Stahls größer als der Wärmeausdehnungskoeffizient des Glases, so dass beim Abkühlen eine Druckeinglasung entsteht, mit anderen Worten der Stahl ummantelt das Glas unter Druck.
Zum besseren Verständnis der Erfindung sind nachfolgend Ausführungsbeispiele anhand der Zeichnung näher erläutert.
Es zeigen
- Fig. 1A: ein wannenförmig ausgebildetes Gehäuseteil mit einem Flansch in Draufsicht,
- Fig. 1B: das wannenförmig ausgebildetes Gehäuseteil mit dem Flansch in seitlicher Schnittdarstellung,
- Fig. 2A: ein zweites wannenförmig ausgebildetes Gehäuseteil mit einem Flansch und mit Laschen in Draufsicht und
- Fig. 2B: das zweite wannenförmig ausgebildete Gehäuseteil mit dem Flansch und den Laschen in seitlicher Schnittdarstellung und
- Fig. 3: ein drittes wannenförmig ausgebildetes Gehäuseteil mit einem gestuft ausgeführten Flansch in seitlicher Schnittdarstellung.

In den verschiedenen Figuren sind ähnliche oder dieselben Elemente durch gleiche Bezugszeichen bezeichnet.

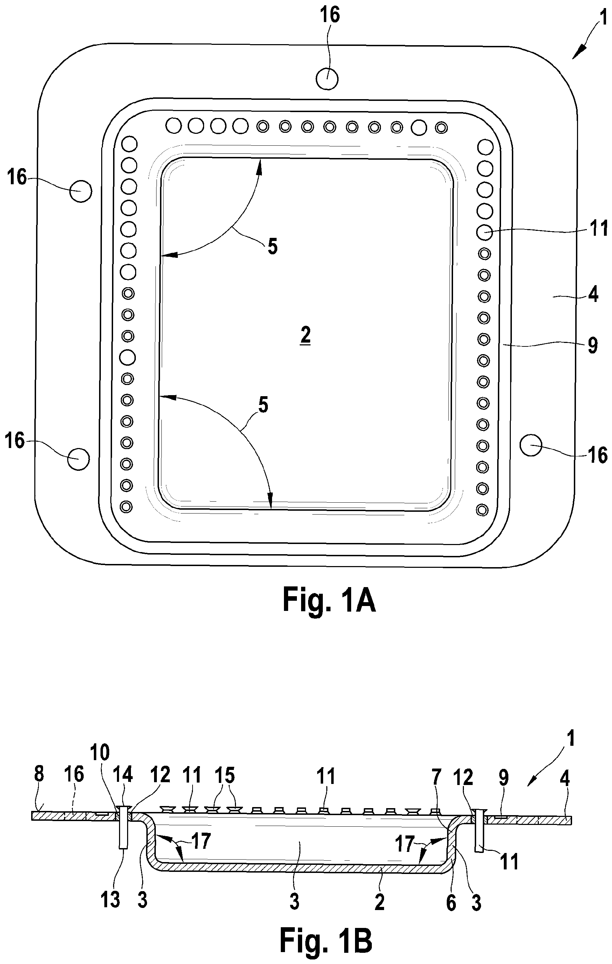

Figur 1A und1B zeigen ein wannenförmig ausgebildetes Gehäuseteil 1 mit einer Bodenwand 2, vier Seitenwänden 3 und einen Flansch 4. Die Bodenwand 2 ist rechteckförmig ausgeformt und jeweils zwei benachbarte Seitenwände 3 nehmen einen rechten Winkel 5 zueinander ein. Der Gehäuseboden 2 und der Flansch 4 sind in parallelen Ebenen und an entgegengesetzten Enden 6, 7 der Seitenwände 3 angeordnet. Die Bodenwand 2, die Seitenwände 3 und der Flansch 4 sind aus einem Werkstück tiefgezogen und von daher einteilig ausgebildet. Der Flansch 4 weist an einer Stirnfläche 8 eine umlaufende Nut 9 auf, in die eine Gehäuseabdeckung einsetzbar und mit dem wannenförmig ausgebildeten Gehäuseteil 1 verschweißbar ist. Zwischen der Nut 9 und den Seitenwänden 3 sind durch den Flansch 4 hindurchgehende Ausnehmungen 10 angeordnet, in die Kontaktstifte 11 einsetzbar sind. Die Kontaktstifte 11 sind von einer Glasfüllung 12 ummantelt und erstrecken sich durch den Flansch 4 des Gehäuseteiles und ragen mit Enden 13, 14 frei aus der Glasfüllung 12 und aus den Flansch 4 hinaus. Während der Herstellung sind die Kontaktstifte 11 frei in den Ausnehmungen 10 gelagert. In einen jeden Zwischenraum zwischen dem Gehäuseteil 1 und den Kontaktstiften 11 wird eine Glastablette, auch als Glasperle bezeichnet, abgelegt. Das Gehäuseteil 1, die Kontaktstifte 11 und die Glasperlen werden erhitzt und jede Glasperle wird so zu einer Glasfüllung 12 eingeschmolzen beziehungsweise gesintert, das jeder Kontaktstift 11 elektrisch isolierend gegenüber dem Gehäuseteil 1 in dem Gehäuseteil 1 von der Glasfüllung 12 ummantelt gelagert ist. Mittels des Schmelzvorgangs wird eine hermetische Abdichtung zwischen jeder Glasfüllung 12 und jedem Kontaktstift 11 und jeder Glasfüllung 12 und dem Gehäuseteil 1 erzielt. Der Schmelzvorgang wird auch als Einglasen bezeichnet. Die Kontaktstifte 11 stehen senkrecht auf einer Bodenwannenebenen und sind zu dieser beabstandet. Kontaktstifte 11 mit vergrößerten Köpfen 15 dienen dazu, zwei Anschlussdrähte an die Köpfe 15 anzubringen, um eine größere Strommenge zu transportieren oder um zwei verschiedene Stellen einer elektronischen Schaltung zu erreichen. Das Anbringen der Anschlussdrähte wird auch als Bonden von Bonddrähten bezeichnet. Zweite durchgehende Ausnehmungen 16 des Flansches 4 dienen zur Befestigung des Gehäuses aus Gehäuseteil 1 und Gehäuseabdeckung innerhalb eines Automatikgetriebes eines Kraftfahrzeuges. Die Gehäuseabdeckung ist auch als Gehäusedeckel bezeichnet. Das metallische Gehäuseteil 1 ist tiefgezogen, um die Wannenform zu erhalten. Die Seitenwände 3 und die Bodenwand 2 nehmen einen Winkel 17 geringfügig größer als 90° zueinander ein. Der Winkel 17 liegt zwischen 90° und 94°.

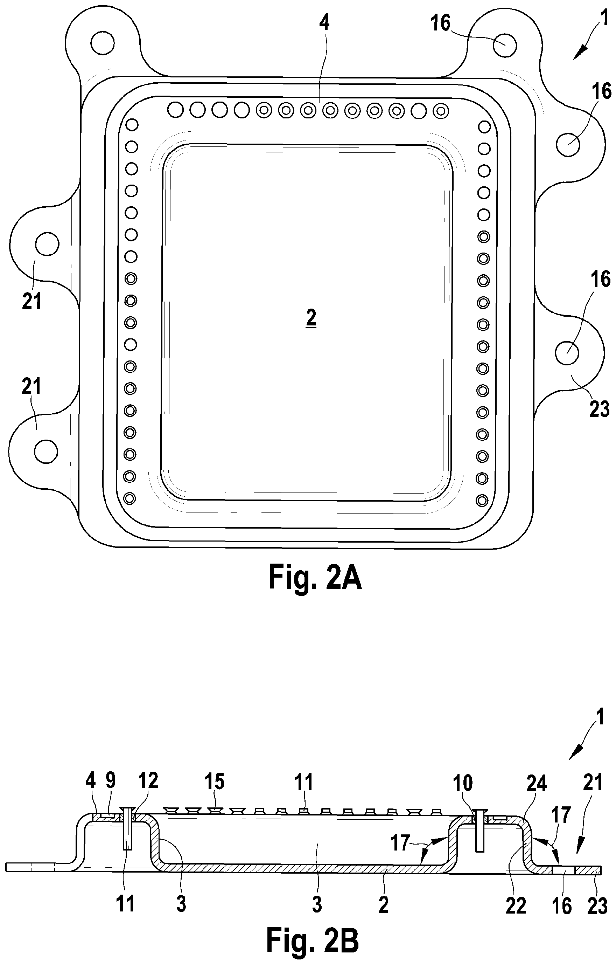

Figur 2A und 2B zeigen ein zweites wannenförmig ausgebildetes Gehäuseteil 1 mit einer Bodenwand 2, vier Seitenwänden 3, einen Flansch 4 und fünf Laschen 21. Die Bodenwand 2, die Seitenwände 3, der Flansch 4 und die fünf Laschen 21 sind aus einem Werkstück tiefgezogen und von daher einteilig ausgebildet. Die einteilig mit dem Gehäuseteil 1 ausgebildeten Laschen 21 sind an dem Flansch 4 angesetzt. Jede Lasche 21 weist zumindest eine durchgehende Ausnehmung 16 zur Befestigung des Gehäuses aus Gehäuseteil 1 und Gehäusedeckel innerhalb des Automatikgetriebes auf. Die Lasche 21 weist zwei Laschenteile 22 und 23 auf, die den Winkel 17 geringfügig größer als 90° zueinander einnehmen. Ein erstes Laschenteil 22 ist mittels eines Bogenteiles 24 so an dem Flansch 4 angesetzt, dass das zweite Laschenteil 23 in derselben Ebene liegt, wie die Bodenwand 2. Nach der Befestigung innerhalb des Automatikgetriebes liegt sowohl das Laschenteil 23 als auch die Bodenwand 2 auf einem ebenen Automatikgetriebeteil auf und wird so sicher und kühlend gehalten.

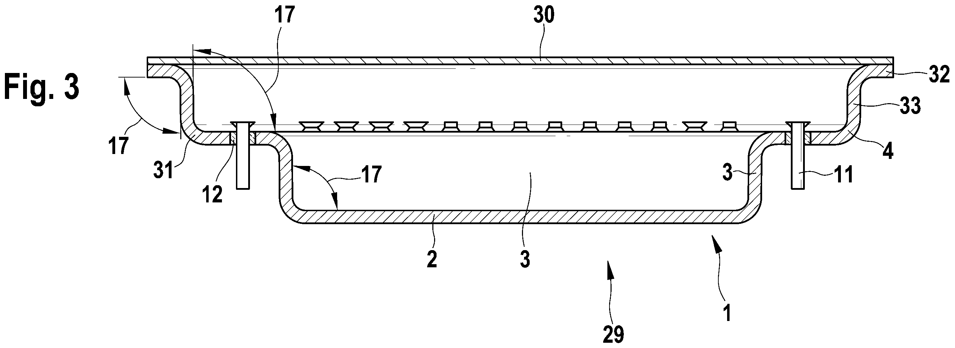

Figur 3 zeigt ein hermetisch dichtes Gehäuse 29 mit einem dritten wannenförmig ausgebildetem Gehäuseteil 1 und einer Gehäuseabdeckung 30. Das dritte wannenförmig ausgebildete Gehäuseteil 1 weist eine Bodenwand 2, vier Seitenwände 3 und einen gestuft ausgeführten Flansch 4 auf. Der gestuft ausgeführte Flansch 4 weist zwei Stufen 31 und 32 und ein Zwischenteil 33 auf. Die Bodenwand 2 und die Stufen 31 und 32 liegen in parallelen Ebenen. Die Seitenwand 3 und das Zwischenteil 33 einer jeden Seite des Gehäuseteiles 1 liegen in parallelen Ebenen. Das Zwischenteil 33 und die Stufen 31 nehmen den Winkel 17 geringfügig größer als 90° zueinander ein. Die erste Stufe 31 weist die durchgehenden Kontaktstiftausnehmungen 10 auf. In der ersten Stufe 31 sind die Kontaktstifte 11 angeordnet. Die zweite Stufe 33 dient zur Befestigung der zweiten als Platte ausgeführten Gehäuseabdeckung 30.

## Patentansprüche

1. Metallisches Gehäuseteil (1) mit mehreren durchgehenden Ausnehmungen (10), in jeder der Ausnehmungen (10) ist eine Glasfüllung (12) angeordnet, jede Glasfüllung (12) verschließt eine Ausnehmung (10) hermetisch dicht und ummantelt einen Kontaktstift (11), der sich durch die Ausnehmung (10) und die Glasfüllung (12) hindurch erstreckt und dessen beide Enden (13, 14) aus der Glasfüllung (12) und der Ausnehmung (10) herausragen, wobei das Gehäuseteil (1) wannenförmig mit einer Bodenwand (2), Seitenwänden (3) und einem Flansch (4) ausgebildet ist,
**dadurch gekennzeichnet, dass**
die Ausnehmungen (10) und die Kontaktstifte (11) in dem Flansch (4) angeordnet sind.

2. Gehäuseteil nach Anspruch 1, **dadurch gekennzeichnet, dass** jeweils zwei benachbarte Seitenwände (3) einen rechten Winkel (5) zueinander einnehmen.

3. Gehäuseteil nach Anspruch 1 und/oder 2, **dadurch gekennzeichnet, dass** der Flansch (4) eine umlaufend Nut (9) aufweist

4. Gehäuseteil nach einem oder mehreren der vorhergehenden Ansprüche 1 - 3, **dadurch gekennzeichnet, dass** der Flansch (4) zumindest eine zweite durchgehende Ausnehmung (16) aufweist

5. Gehäuseteil nach einem oder mehreren der vorhergehenden Ansprüche 1-4, **dadurch gekennzeichnet, dass** an dem Flansch (4) zumindest eine Lasche (21) mit einer durchgehenden Ausnehmung (16) angeordnet ist.

6. Gehäuseteil nach Anspruch 5, **dadurch gekennzeichnet, dass** die Lasche (21) zumindest ein Laschenteil (23) mit einer durchgehenden Ausnehmung (16) aufweist, das in derselben Ebene wie die Bodenwand (2) liegt.

7. Gehäuseteil nach einem oder mehreren der vorhergehenden Ansprüche 1 - 6, **dadurch gekennzeichnet, dass** der Flansch (4) zwei Stufen (31, 32) aufweist.

8. Gehäuseteil nach Anspruch 1, **dadurch gekennzeichnet, dass** die Kontaktstifte (11) aus Edelstahl gefertigt sind.

9. Verfahren zur Herstellung eines Gehäuseteiles (1) nach einem der Ansprüche 1 bis 8 mit folgenden Verfahrensschritten:
- die Bodenwand 2, die Seitenwände 3 und der Flansch 4 werden aus einem metallischen Werkstück tief gezogen und
- Kontaktstifte werden in den Ausnehmungen (10) des metallischen Gehäuseteiles (1) eingeglast.

## Claims

1. Metal housing part (1) having a plurality of continuous recesses (10), a glass filling (12) being arranged in each of the recesses (10), each glass filling (12) closing a recess (10) in a hermetically sealed manner and sheathing a contact pin (11) which extends through the recess (10) and the glass filling (12) and of which the two ends (13, 14) protrude out of the glass filling (12) and the recess (10), wherein the housing part (1) is designed in the manner of a trough with a base wall (2), side walls (3) and a flange (4), **characterized in that** the recesses (10) and the contact pins (11) are arranged in the flange (4).

2. Housing part according to Claim 1, **characterized in that** in each case two adjacent side walls (3) form a right angle (5) in relation to one another.

3. Housing part according to Claim 1 and/or 2, **characterized in that** the flange (4) has a circumferential groove (9).

4. Housing part according to one or more of the preceding Claims 1-3, **characterized in that** the flange (4) has at least one second continuous recess (16).

5. Housing part according to one or more of the preceding Claims 1-4, **characterized in that** at least one lug (21) with a continuous recess (16) is arranged on the flange (4).

6. Housing part according to Claim 5, **characterized in that** the lug (21) has at least one lug part (23) with a continuous recess (16), which lug part is situated in the same plane as the base wall (2).

7. Housing part according to one or more of the preceding Claims 1-6, **characterized in that** the flange (4) has two steps (31, 32).

8. Housing part according to Claim 1, **characterized in that** the contact pins (11) are manufactured from stainless steel.

9. Method for producing a housing part (1) according to one of Claims 1 to 8, comprising the following method steps:
- the base wall (2), the side walls (3) and the flange (4) are deep-drawn from a metal workpiece, and
- contact pins are glazed into the recesses (10) of the metal housing part (1).

## Revendications

1. Pièce de boîtier métallique (1) présentant plusieurs évidements traversants (10), une garniture de verre (12) est disposée dans chacun des évidements (10), chaque garniture de verre (12) ferme hermétiquement un évidement (10) et enrobe une tige de contact (11), qui s'étend à travers l'évidement (10) et la garniture de verre (12) et dont les deux extrémités (13, 14) sortent hors de la garniture de verre (12) et de l'évidement (10), dans laquelle la pièce de boîtier (1) est réalisée en forme de cuvette avec une paroi de fond (2), des parois latérales (3) et une bride (4), **caractérisée en ce que** les évidements (10) et les tiges de contact (11) sont disposées dans la bride (4).

2. Pièce de boîtier selon la revendication 1, **caractérisée en ce que** deux parois latérales voisines (3) forment chaque fois entre elles un angle droit (5).

3. Pièce de boîtier selon la revendication 1 et/ou 2, **caractérisée en ce que** la bride (4) présente une rainure périphérique (9).

4. Pièce de boîtier selon une ou plusieurs des revendications précédentes 1 à 3, **caractérisée en ce que** la bride (4) présente au moins un deuxième évidement traversant (16).

5. Pièce de boîtier selon une ou plusieurs des revendications précédentes 1 à 4, **caractérisée en ce qu'**au moins une patte (21) avec un évidement traversant (16) est disposée sur la bride (4).

6. Pièce de boîtier selon la revendication 5, **caractérisée en ce que** la patte (21) présente au moins une partie de patte (23) avec un évidement traversant (16), qui se trouve dans le même plan que la paroi de fond (2).

7. Pièce de boîtier selon une ou plusieurs des revendications précédentes 1 à 6, **caractérisée en ce que** la bride (4) présente deux degrés (31, 32).

8. Pièce de boîtier selon la revendication 1, **caractérisée en ce que** les tiges de contact (11) sont fabriquées en acier allié.

9. Procédé de fabrication d'une pièce de boîtier (1) selon l'une quelconque des revendications 1 à 8, présentant les étapes de procédé suivantes:
- la paroi de fond (2), les parois latérales (3) et la bride (4) sont embouties à partir d'une pièce métallique, et
- des tiges de contact sont vitrifiées dans les évidements (10) de la pièce de boîtier métallique (1) .
